# EUROPEAN PATENT APPLICATION

(11) **EP 4 474 195 A1**
(43) Date of publication of application: **11.12.2024**
(21) Application number: 23178441.4
(22) Date of filing: 09.06.2023
(51) Int. Cl.: B60L 3/00, B60L 3/12

(54) **DETECTION OF A WAKE UP SIGNAL INDICATIVE OF A SAFETY EVENT IN A BATTERY**

(71) Applicant: VOLVO TRUCK CORPORATION, 405 08 Göteborg (SE)
(72) Inventor: Dripta, RAY, 412 76 Göteborg (SE); PALM, Caroline, 411 05 Göteborg (SE)
(74) Representative: Valea AB

(57) **Abstract**

A computer system (600) comprising processing circuitry (602) configured to handle detection of a wake up signal (30) is provided. The wake up signal is indicative of a hazard in a battery (25) associated with a vehicle (1). The processing circuitry (602) is further configured to:
- during one or more detection periods, attempt to detect the wake up signal (30), and
- during one or more idle periods, refrain from attempting to detect the wake up signal (30).

## Description

### TECHNICAL FIELD

The disclosure relates generally to handling detection of a wake up signal. In particular aspects, the disclosure relates to handling detection of a wake up signal indicative of a safety event in a battery. The disclosure can be applied to heavy-duty vehicles, such as trucks, buses, and construction equipment, among other vehicle types. Although the disclosure may be described with respect to a particular vehicle, the disclosure is not restricted to any particular vehicle.

### BACKGROUND

When vehicles go into low power mode, such as in a parking mode, hazards, such as thermal events, also known as thermal runaway, may still occur in batteries of the vehicle, even if in an idle state. These hazards may for example be a fast increase of temperature, or that the temperature in the battery is above a threshold. Alternatively, the hazards may be identified as a fast increase of temperature or that the temperature in a battery being above a threshold. Alternatively, the hazards may be identified as sudden changes in voltage and/or as an increase in battery pressure. When there is a hazard, there may be a risk related to the battery, e.g., the battery may break and become unusable.

To avoid dangers of hazards/thermal events, a Battery Management System (BMS) can, using an associated sensing circuity, measure a status of the battery and/or its cell. When measurements of the sensing circuit indicates a hazardous state, the BMS may send to a vehicle control system, e.g., an Electronic Control Unit (ECU) of the vehicle, wake up signals, which is to indicate to the vehicle control system to wake up such that it can alert of a potential danger.

Current solutions in vehicle applications may include to have a Wake on-Controller Area Network (CAN) for wake-up, or even wireless wake-up, where a main controller, e.g., the ECU, of the vehicle can wake-up on incoming CAN messages or through a wireless communication.

Hence, there is a strive to improve energy efficiency for handling hazards in batteries.

### SUMMARY

According to a first aspect of the disclosure, a computer system comprising processing circuitry is configured to handle detection of a wake-up signal indicative of a hazard in a battery associated with a vehicle. The processing circuitry is further configured to:
a. during one or more detection periods, attempt to detect the wake-up signal, and
b. during one or more idle periods, refrain from attempting to detect the wake-up signal.

In other words, the process of detecting the wake-up signal indicative of the hazard is, instead of always trying to detect the wake-up signal, split up into the one or more detection periods and the one or more idle periods.

The first aspect of the disclosure may seek to solve the problem of high energy consumption when handling wake-up signals for batteries. A technical benefit may include improving energy efficiency of handling wake-up signals. This is since due to the one or more idle periods, there is no need to attempt to detect the wake-up signal, and hence, no power, or very little power, e.g., below a threshold, is consumed during the one or more idle periods. Safety is still maintained as the wake-up signal is detected when sent during the one or more detection periods.

In the one or more idle periods, the computer system may configure itself to reduce power consumption. Additionally or alternatively, in the one or more idle periods, the computer system may be configured to not receive wake-up signals, and instead to be idle, e.g. to not consume power, or to consume a minimum or low amount of power, e.g., below a threshold.

Optionally in some examples, including in at least one preferred example, during the one or more detection periods and/or the one or more idle periods, the vehicle is arranged in a low power mode. The low power mode may be a parking mode.

A technical benefit may include improved energy efficiency. This is since the vehicle has configured a plurality of components into idle mode. In idle mode, the plurality of components may consume no power, or little power, e.g., less than a threshold of power. As an example, an engine may be turned off. A brake system may be turned off. However, some auxiliary components may still be turned on, e.g., a radio and/or lights.

Optionally in some examples, including in at least one preferred example, the processing circuitry is further configured to determine a respective duration associated with any one or both out of the one or more detection periods and the one or more idle periods based on one or more parameters.

The one or more parameters comprising any one or more out of:
a. a State of Health (SoH), indicator of the battery,
b. a usage profile of the battery, and
c. an environmental parameter associated with the battery and/or the vehicle.

In other words, the time to spend attempting to detect the wake-up signal, and the time spent refraining from attempting to detect the wake-up signal may be based on the above parameters which may indicate how likely it is that a hazard will occur and/or how urgent it is to detect the wake-up signal. Thereby the one or more idle periods and/or the one or more detection periods may be configured accordingly.

A technical benefit may include improved energy efficiency. This is since the one or more idle periods and/or the one or more detection periods may be adapted to detect the wake-up signal as often as is needed in the one or more detection periods, while still allowing to be idle in the one or more idle periods as much as possible, and thereby improving energy efficiency while maintaining safety.

Optionally in some examples, including in at least one preferred example, when the one or more parameters comprise the usage profile of the battery, the processing circuitry is configured to determine the respective duration associated with any one or both out of the one or more detection periods and the one or more idle periods based on one or more parameters, by any one or more out of:
a. when the usage profile of the battery indicates a charge or discharge of the battery to be below a predefined intensity threshold, the duration of the one or more detection periods is determined to be a first detection duration, and/or the duration of the one or more idle periods is determined to be a first idle duration, and
b. when the usage profile of the battery indicates a charge or discharge of the battery to be above a predefined intensity threshold, the duration of the one or more detection periods is determined to be a second detection duration, and/or the duration of the one or more idle periods is determined to be a second idle duration.

In the above example, the first detection duration is shorter than the second detection duration and/or the first idle duration is longer than the second idle duration.

In the above example, the usage profile may relate to a number of charge/discharge cycles. Additionally or alternatively, the usage profile may relate to a power intensity, e.g., a peak power and/or a power consumed over time.

A technical benefit may include improved energy efficiency. This is since the one or more idle periods and/or the one or more detection periods may be adapted to detect the wake-up signal as often as is needed in the one or more detection periods based on the usage profile, while still allowing to be idle in the one or more idle periods as much as possible, and thereby improving energy efficiency while maintaining safety.

Optionally in some examples, including in at least one preferred example, when the one or more parameters comprise the SoH indicator of the battery, the processing circuitry is configured to determine the respective duration associated with any one or both out of the one or more detection periods and the one or more idle periods based on one or more parameters, by any one or more out of:
a. when the SoH indicates that the SoH of the battery fulfils a quality condition , the duration of the one or more detection periods is determined to be a first detection duration, and/or the duration of the one or more idle periods is determined to be a first idle duration, and
b. when the SoH indicates that the SoH of the battery does not fulfil the quality condition, the duration of the one or more detection periods is determined to be a second detection duration, and/or the duration of the one or more idle periods is determined to be a second idle duration.

In the above example, the first detection duration is shorter than the second detection duration and/or the first idle duration is longer than the second idle duration.

A technical benefit may include improved energy efficiency. This is since the one or more idle periods and/or the one or more detection periods may be adapted to detect the wake-up signal as often as is needed in the one or more detection periods based on the SoH of the battery, while still allowing to be idle in the one or more idle periods as much as possible, and thereby improving energy efficiency while maintaining safety.

Optionally in some examples, including in at least one preferred example, the processing circuitry is further configured to receive at least part of the one or more parameters from a BMS associated with the battery.

A technical benefit may include improved energy efficiency. This is since the BMS is arranged to manage the battery and may provide any suitable parameter as part of the one or more parameters to indicate the state of the battery, e.g., the SoH or the usage profile, such that the one or more detection periods and/or the one or more idle periods may be configured accordingly for improved energy efficiency.

Optionally in some examples, including in at least one preferred example, the processing circuitry is further configured to determine the respective duration associated with any one or both out of the one or more detection periods and the one or more idle periods based on a timing configuration indicative of when the wake-up signal can be transmitted from a BMS associated with the battery.

A technical benefit may include improved energy efficiency. This is since the one or more detection periods and/or the one or more idle periods may be configured according to a timing configuration of the wake-up signal. This means that the one or more detection periods may be configured or arranged to be synchronized with the timing configuration, i.e. such that the one or more detection periods match when the wake-up signal may be transmitted. This may further mean that the one or more idle periods may be increased in duration for improved energy efficiency.

Optionally in some examples, including in at least one preferred example, the timing configuration is indicative of any one or more out of:
a. one or more first BMS time periods when the BMS is configured to transmit the wake-up signal in response to a sensed hazard of the battery,
b. one or more second BMS time periods when the BMS is configured to refrain from detecting sensed hazards of the battery.

A technical benefit may include improved energy efficiency. This is since the wake-up signal will be detected synchronized to when the BMS and/or a transmitter thereof will send the wake-up signal, and the computer system and/or the receiver in the computer system may be idle more often and thereby energy efficiency is improved.

Optionally in some examples, including in at least one preferred example, the processing circuitry is further configured to: in response to detecting the wake-up signal, triggering an alert. The alert may e.g., be a sound and/or light alarm internally and/or externally to the vehicle, and/or an alert sent remotely to a control station or authorities, e.g., an SOS alarm.

A technical benefit may include improved safety. This is since a user of the vehicle, e.g., a driver presently sleeping in the vehicle, may be awoken to prevent any danger. Additionally or alternatively, persons in the vicinity of the vehicle and/or any other suitable person or entity may be warned of the hazard.

According to a second aspect of the disclosure, a vehicle is provided. The vehicle comprises the computer system of the first aspect. The second aspect of the disclosure may seek to solve the problem of high energy consumption when handling wake-up signals for batteries. A technical benefit may include improving energy efficiency of handling wake-up signals. The technical benefit correspond to the benefits of the first aspect. All embodiments of the first aspect may apply to the second aspect and vice versa.

According to a third aspect of the disclosure, a computer-implemented method for handling detection of a wake-up signal indicative of a hazard in a battery associated with a vehicle is provided. The vehicle may be the method may be implemented in the computer system of the first aspect.

The method of the third aspect comprises:
by a processing circuitry comprised in a computer system, during one or more detection periods, attempting to detect the wake-up signal, and
by the processing circuitry, during one or more idle periods, refraining from attempting to detect the wake up signal.

The third aspect of the disclosure may seek to solve the problem of high energy consumption when handling wake up signals for batteries. A technical benefit may include improving energy efficiency of handling wake up signals. This is since due to the one or more idle periods, there is no need to attempt to detect the wake up signal, and hence, no power, or very little power, e.g., below a threshold, is consumed during the one or more idle periods. Safety is still maintained as the wake up signal is detected when sent during the one or more detection periods.

Optionally in some examples, including in at least one preferred example, during the one or more detection periods and/or the one or more idle periods, the vehicle is arranged in a low power mode, such as in a parking mode.

A technical benefit may include improved energy efficiency. This is since the vehicle has configured a plurality of components into idle mode. In idle mode, the plurality of components may consume no power, or little power, e.g., less than a threshold of power. In some examples, an engine may be turned off and/or a brake system may be turned off. However, some auxiliary components may still be turned on, e.g., a radio and/or lights.

Optionally in some examples, including in at least one preferred example, the method further comprises: by the processing circuitry, determining a respective duration associated with any one or both out of the one or more detection periods and the one or more idle periods based on one or more parameters, the one or more parameters comprising any one or more out of:
a. a State of Health, SoH, indicator of the battery,
b. a usage profile of the battery, and
c. an environmental parameter associated with the battery and/or the vehicle, e.g., an ambient temperature and/or an atmospheric pressure of the battery and/or the vehicle.

A technical benefit may include improved energy efficiency. This is since the one or more idle periods and/or the one or more detection periods may be adapted to detect the wake up signal as often as is needed in the one or more detection periods, while still allowing to be idle in the one or more idle periods as much as possible, and thereby improving energy efficiency while maintaining safety.

Optionally in some examples, including in at least one preferred example, the one or more parameters comprise the usage profile of the battery, determining the respective duration associated with any one or both out of the one or more detection periods and the one or more idle periods based on one or more parameters, comprises any one or both out of:
a. when the usage profile of the battery indicates a charge or discharge of the battery to be below a predefined intensity threshold , determining the duration of the one or more detection periods to a first detection duration, and/or determining the duration of the one or more idle periods to a first idle duration, and
b. when the usage profile of the battery indicates a charge or discharge of the battery to be above a predefined intensity threshold, determining the duration of the one or more detection periods to a second detection duration, and/or determining the duration of the one or more idle periods to a second idle duration;

In the above example, the first detection duration is shorter than the second detection duration and/or the first idle duration is longer than the second idle duration.

A technical benefit may include improved energy efficiency. This is since the one or more idle periods and/or the one or more detection periods may be adapted to detect the wake up signal as often as is needed in the one or more detection periods based on the usage profile, while still allowing to be idle in the one or more idle periods as much as possible, and thereby improving energy efficiency while maintaining safety.

Optionally in some examples, including in at least one preferred example, when the one or more parameters comprise the SoH indicator of the battery, determining the respective duration associated with any one or both out of the one or more detection periods and the one or more idle periods based on one or more parameters, comprises any one or more out of:
a. when the SoH indicates that the SoH of the battery fulfils a quality condition, determining the duration of the one or more detection periods to a first detection duration, and/or determining the duration of the one or more idle periods to a first idle duration, and/or
b. when the SoH indicates that the SoH of the battery does not fulfil the quality condition, determining the duration of the one or more detection periods to a second detection duration, and/or determining the duration of the one or more idle periods to a second idle duration.

In the above example, the first detection duration is shorter than the second detection duration and/or the first idle duration is longer than the second idle duration.

A technical benefit may include improved energy efficiency. This is since the one or more idle periods and/or the one or more detection periods may be adapted to detect the wake up signal as often as is needed in the one or more detection periods based on the SoH of the battery, while still allowing to be idle in the one or more idle periods as much as possible, and thereby improving energy efficiency while maintaining safety.

Optionally in some examples, including in at least one preferred example, the method further comprises: by the processing circuitry, receiving at least part of the one or more parameters from a Battery Management System, BMS, associated with the battery.

A technical benefit may include improved energy efficiency. This is since the BMS is arranged to manage the battery and may provide any suitable parameter as part of the one or more parameters to indicate the state of the battery, e.g., the SoH or the usage profile, such that the one or more detection periods and/or the one or more idle periods may be configured accordingly for improved energy efficiency.

Optionally in some examples, including in at least one preferred example, determining the respective duration associated with any one or both out of the one or more detection periods and the one or more idle periods is based on a timing configuration indicative of when the wake up signal can be transmitted from a BMS associated with the battery.

A technical benefit may include improved energy efficiency. This is since the one or more detection periods and/or the one or more idle periods may be configured according to a timing configuration of the wake up signal. This means that the one or more detection periods may be configured or arranged to be synchronized with the timing configuration, i.e. such that the one or more detection periods match when the wake up signal may be transmitted. This may further mean that the one or more idle periods may be increased in duration for improved energy efficiency.

Optionally in some examples, including in at least one preferred example, the timing configuration is indicative of any one or more out of:
a. one or more first BMS time periods when the BMS is configured to transmit a wake up signal in response to a sensed hazard of the battery,
b. one or more second BMS time periods when the BMS is configured to refrain from detecting sensed hazards of the battery.

A technical benefit may include improved energy efficiency. This is since the wake up signal will be detected synchronized to when the BMS and/or a transmitter thereof will send the wake up signal, and the computer system and/or the receiver in the computer system may be idle more often and thereby energy efficiency is improved.

Optionally in some examples, including in at least one preferred example, the method further comprises: by the processing circuitry, in response to detecting the wake up signal, triggering an alert.

A technical benefit may include improved safety. This is since a user of the vehicle, e.g., a driver presently sleeping in the vehicle, may be awoken to prevent any danger. Additionally or alternatively, persons in the vicinity of the vehicle and/or any other suitable person or entity may be warned of the hazard.

According to a fourth aspect of the disclosure, a computer program product is provided. The computer program product comprises program code for performing, when executed by a processing circuitry, the method according to the third aspect. The processing circuitry may be the processing circuitry of the computer system according to the first aspect.

The fourth aspect of the disclosure may seek to solve the problem of high energy consumption when handling wake up signals for batteries. A technical benefit may include improving energy efficiency of handling wake up signals. The technical benefit correspond to the benefits of the first, second and/or third aspect. All embodiments of the first, second, and/or third aspect may apply to the fourth aspect and vice versa.

According to a fifth aspect of the disclosure, a non-transitory computer-readable storage medium is provided. The non-transitory computer-readable storage medium comprises instructions, which when executed by a processing circuitry, cause the processing circuitry to perform the method according to the third aspect. The processing circuitry may be the processing circuitry of the computer system according to the first aspect.

The fifth aspect of the disclosure may seek to solve the problem of high energy consumption when handling wake up signals for batteries. A technical benefit may include improving energy efficiency of handling wake up signals. The technical benefit correspond to the benefits of the first, second, third, and/or fourth aspect. All embodiments of the first, second, third and/or fourth aspect may apply to the fifth aspect and vice versa.

The disclosed aspects, examples (including any preferred examples), and/or accompanying claims may be suitably combined with each other as would be apparent to anyone of ordinary skill in the art. Additional features and advantages are disclosed in the following description, claims, and drawings, and in part will be readily apparent therefrom to those skilled in the art or recognized by practicing the disclosure as described herein.

There are also disclosed herein computer systems, control units, code modules, computer-implemented methods, computer readable media, and computer program products associated with the above discussed technical benefits.

### BRIEF DESCRIPTION OF THE DRAWINGS

**FIG. 1** is an exemplary system diagram of a vehicle according to an example.
**FIG. 2** is a flow chart of an exemplary method according to an example.
**FIG. 3** is a schematic diagram illustrating an example scenario.
**FIG. 4** is another view of **FIG. 1****,** according to an example.
**FIG. 5** is a flow chart of an exemplary method according to an example.
**FIG.** 6 is a schematic diagram of an exemplary computer system for implementing examples disclosed herein, according to an example.

### DETAILED DESCRIPTION

The detailed description set forth below provides information and examples of the disclosed technology with sufficient detail to enable those skilled in the art to practice the disclosure.

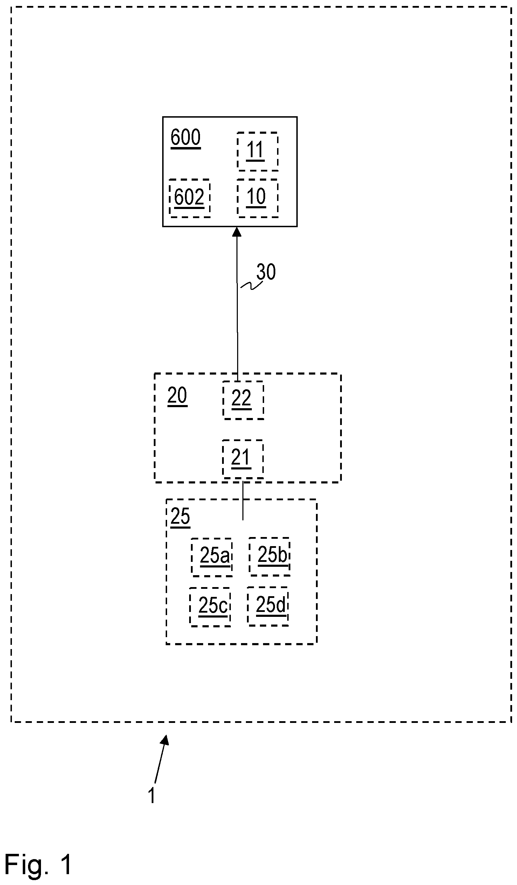

**FIG. 1** is an exemplary system diagram of a vehicle 1 according to an example. The **vehicle 1** may be any suitable vehicle which comprises **a battery 25.** In some examples, the vehicle 1 comprises a vehicle unit, e.g., a trailer which comprises the battery 25. The vehicle 1 may for example be any one of a heavy-duty vehicle, a truck, a bus, a marine vessel, a car, a combination vehicle, a wheel loader, a semi-truck, a tractor, or a motorcycle. The vehicle 1 is not limited to a land vehicle, but may also be a marine vessel or an aircraft, e.g.,, a helicopter, an airplane, or an unmanned aerial vehicle.

The vehicle 1 may in examples herein be arranged in a low power mode. This means that electrical machines of the vehicle 1 may be powered off or be in an idle mode, e.g., as controlled by **an ECU 11.** The ECU 11 may also be in an idle mode, e.g., which may be woken up during a hazard in the battery 25 by receipt of a wake up signal. Waking up the ECU 11 may mean to switch the ECU 11 from an idle mode to a normal operation mode.

The vehicle 1 may comprise a **receiver 10** arranged for receiving wake up signals such as a **wake up signal 30.** The receiver 10 may be a wireless or wired receiver. The wake up signal 30 may be indicative of a hazard in the battery 25, e.g., a thermal runaway in the battery 25.

The wake up signal 30 may be a wireless signal, or alternatively a signal transmitted on a wire, e.g., a CAN bus signal.

The receiver 10 may be configured to, during one or more detection periods, detect the wake up signal 30.

The receiver 10 may be configured to, during one or more idle periods, refrain from detecting the wake up signal 30, and e.g., instead be in a low power mode to save power.

The one or more detection periods and the one or more idle periods may also be referred to as duty cycling the receiver 10 until a wake-up signal is received. Once the receiver 10 has detected the message to wake up, i.e. the wake up signal 30, the receiver 10 will wake the ECU 11 and/or the vehicle 1.

The wake up signal 30 may be transmitted by a **BMS 20.** The BMS 20 may use a **transmitter 22** to transmit the wake up signal. The transmitter 22 may be a wireless or wired transmitter.

The BMS 20 may transmit the wake up signal 30 when a **sensor 21** senses a hazard, e.g., a thermal event such as a thermal runaway, in the battery 25. The hazard may be related to the battery 25 as a whole, or related to **one or more cells 25a, 25b, 25c, 25d** of the battery 25.

The sensor 21 may be a sensing circuit 21.

The sensor 21 may monitor events in the battery 25, e.g., power, temperature, and/or pressure. Sensor measurements of the sensor 21 may be referred to as a signature. The signature may be sensor data measured over a set time period.

The sensor 21 may always be turned on, e.g., always monitoring the battery 25 and/or the **one or more cells 25a, 25b, 25c, 25d** of the battery 25.

If a signature or sensor data of the sensor 21 is indicating a hazard, e.g., a thermal event or a risk for a thermal event, is detected by the sensor 21, the BMS 20 may be turned on, e.g., switched to the BMS 20 transmitting period, to further rationalize the signature or sensor data and forward/transmit a message of the hazard to the receiver 10, and finally forwarded/transmitted to a main controller of the vehicle 1, e.g., the ECU 11.

The battery 25 may for example be a battery in a trailer of the vehicle 1, or a battery associated with powering an electric motor of the vehicle 1. Additionally or alternatively, the battery 25 may be any one or more out of:
a. an auxiliary battery which is used to power all the ECUs of the vehicle 1, e.g., including accessories in the vehicle 1, and
b. one or more battery pack(s) which is part of a high voltage system of the vehicle 1.

The battery 25 may be a battery of any suitable battery type,. E.g., Lithium-Ion battery of various chemistries, sodium-ion battery, lithium-metal battery, etc.

The battery 25 may be a battery pack comprising the **one or more cells 25a, 25b, 25c, 25d.**

The BMS 20 may be any suitable BMS, e.g., a centralized BMS, distributed BMS and/or a modular BMS. A centralized BMS may be a monolithic BMS organized in one entity in relation to the battery 25, e.g., adjacent or directly coupled with the battery 25. A distributed BMS may comprise a plurality of entities, e.g., each entity being adjacent to or coupled with different batteries.

The BMS 20 may be able to control and/or measure data of the battery 25 using the sensor 21. The measured data may be any one or more out of: temperature, power, pressure, current, voltage, and/or any other suitable parameter.

The BMS 20 may further control plurality of modules or a plurality of battery packs.

The BMS 20 may be able to configure itself into idle BMS periods and transmitting BMS periods. In the idle periods the BMS 20 may be in a low power mode. In the transmitting BMS periods the BMS 20 may be able to transmit the wake up signal 30.

The BMS 20 may be able to synchronize the idle BMS periods and/or transmitting BMS periods with the one or more idle periods and/or the one or more detection periods of the receiver 10, e.g., with respect to duration and/or timing.

In some examples, the idle BMS periods and/or transmitting BMS periods are initially synchronized with the one or more idle periods and/or the one or more detection periods of the receiver 10, e.g., with respect to duration and/or timing.

The BMS 20 may detect a hazard, e.g., thermal event, in the battery 25 by detection by the sensor 21. If the BMS 20 is configured in a transmitting BMS period, the BMS 20 may, using the transmitter 22, transmit the wake up signal 30 to the receiver 10, indefinitely, until received by the receiver 10, e.g., indicated by a response, or when the ECU 11 and/or vehicle 1 is switched to a normal operations mode.

If the BMS 20 is configured in an idle BMS period, the BMS 20 may wait until the BMS 20 is in the BMS transmitting period before transmitting the wake-up signal 30.

After receiving a signature, i.e. a measurement, from the sensor 21, the BMS 20 may rationalize the signature and then send the wake- up signal 30. The BMS 20 may wait for a next subsequent/immediate time period for sending the wake-up signal 30.

In some examples herein, the battery 25 is an energy storage system.

While a vehicle has been exemplified in the examples herein, examples herein may also apply to batteries and/or energy storage systems in any other suitable stand-alone applications.

Some examples herein may be performed at least partly by a computer system 600, and/or a processing circuitry 602 therein. The processing circuitry 602 may be one or more processors, and/or any suitable processing circuitry.

The computer system 600 and/or the processing circuitry 602 may be comprised in the vehicle 1. The computer system 600 and/or the processing circuitry 602 may also be comprised in a remote location communicatively coupled to vehicle 1. The computer system 600 and/or the processing circuitry 602 may in some examples be comprised in a server or a control station, e.g., which may be arranged to at least partly remotely control and/or to provide instructions to the vehicle 1.

The computer system 600 and/or the processing circuitry 602 may further, directly and/or indirectly, control and/or communicate with any suitable entity comprised in the vehicle 1 e.g., sensors and/or actuators of the vehicle 1.

The computer system 600 and/or the processing circuitry 602 may be able to control the receiver 11 and/or the ECU 11.

For example, the computer system 600 and/or the processing circuitry 602 may be able to configure one or more detection periods and a duration thereof of when the receiver 10 shall detect the wake up signal 30. Additionally or alternatively, the computer system 600 and/or the processing circuitry 602 may be able to configure one or more idle periods and a duration thereof of when the receiver 10 shall refrain from detecting the wake up signal 30, and instead be idle to save power.

The computer system 600 and/or the processing circuitry 602 may be able to configure the vehicle 1 and/or the ECU 11 to be in a low power mode, e.g., in parking mode.

The computer system 600 and/or the processing circuitry 602 may be able to configure the vehicle 1 and/or the ECU 11 to wake up from said low power mode, e.g., to switch to a normal operations mode, e.g., in response to receipt of the wake up signal 30.

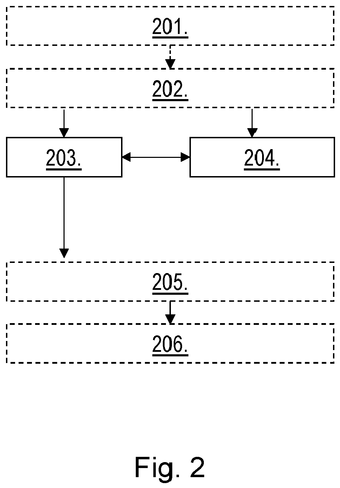

**FIG. 2** is a flow chart of an exemplary method according to an example.

The exemplary method according to FIG. 2 is a computer-implemented method for handling detection of the wake up signal 30 indicative of a hazard in the battery 25 associated with the vehicle 1. The hazard may be a thermal event or also referred to as a thermal runaway of the battery 25.

The exemplary method may relate to detecting the wake up signal 30 in the one or more detection periods, and to be idle in the one or more idle periods. In this way, the method may detect wake up signals as often as needed during the one or more detection periods while being able to save power during the one or more idle periods. Furthermore, the duration of the one or more detection periods, and/or the one or more idle periods may be determined as part of the exemplary method, e.g., based on a current state of the battery 25.

The exemplary method may be performed by the computer system 600 and/or the processing circuitry 602 therein.

When performing the exemplary method of FIG. 2, the vehicle 1 may be arranged in a low power mode, such as in a parking mode. This may mean that the vehicle 1 has powered down at least some or all functionality, e.g., which functionality may otherwise be powered by the battery 25.

The low power mode may not only concern functions otherwise directly powered by a High Voltage (HV) battery, but may also concern functions powered by a Low Voltage (LV) battery e.g., 12V or 24V battery, which is usually used to supply power to the vehicle 1 ECUs and functions. The battery 25 may in some examples be a HV battery or LV battery.

The exemplary method may comprise the following actions, in any suitable order. Optional actions are illustrated with dashed lines in FIG. 2.

### Action 201

In some examples, the method comprises, by the processing circuitry 602, receiving at least part of one or more parameters from the BMS 20 associated with the battery 25.

The one or more parameters may be received by the receiver 10, and transmitted by the transmitter 22 of the BMS 20, or obtained in any other suitable manner.

The one or more parameters may comprise any one or more out of:
a. a SoH indicator of the battery 25,
b. a usage profile of the battery 25, and
c. an environmental parameter associated with the battery 25 and/or the vehicle 1, e.g., an ambient temperature and/or an atmospheric pressure of the battery 25 and/or the vehicle 1.

The SoH indicator may indicate the SoH of the battery 25 using any suitable metric. The SoH indicated by the SoH indicator may be for one or more cells of the battery 25 and/or for the battery 25 as a whole. The SoH indicated by the SoH indicator may be value, e.g., a quantification of the SoH of the battery 25. The SoH indicated by the indicator may be a function of many different parameters and/or measurements and may be based on any suitable predetermined model for quantifying the SoH. For example, the SoH indicated by the SoH indicator may be a function of any one or more out of:
a. an internal resistance, impedance and/or conductance of the battery 25,
b. a capacity of the battery 25,
c. a voltage of the battery 25
d. a self-discharge of the battery 25,
e. an ability of the battery 25 to accept a charge,
f. a number of charge/discharge cycles over a period of time of the battery 25,
g. an age of the battery 25,
h. a temperature of battery 25 during previous usage,
i. a current temperature of battery 25, and
j. total energy charged and discharged of the battery 25.

If the SoH indicate may, e.g., by use of a predefined model and/or quantified to a value using a predefined model, indicate that the risk of a hazard may be higher than a threshold, and therefore increased need for detecting wake up signals may be needed.

A rate of change of the SoH above a threshold may also indicate an increased risk of a hazard.

While at least part of the one or more parameters may be received from the BMS 20, e.g., as measured by the BMS 20, as exemplified in further actions below, the one or more parameters may further be obtained in any other suitable manner. As an example, all or at least part of the one or more parameters may also be preconfigured and/or measured/determined/obtained by the computer system 600 and/or the processing circuitry 602 therein.

The usage profile of the battery 25 may indicate a usage, e.g., any one or more out of charge/discharge cycles of the battery 25, power consumed by the battery 25, and/or a max peak power consumed by the battery 25, e.g., during a time period of a predefined duration. The time period may be a most recent time period or a most recent time period before the vehicle 1 was configured in a low power mode, e.g., a parking mode.

If the usage profile indicates an increased usage, e.g., compared to a previous measurement or compared to a predefined usage profile, e.g., an average usage, then the risk of a hazard may be higher than a threshold, and therefore increased need for detecting wake up signals may be needed.

For example, if the usage profile indicates more discharge cycles than a predefined threshold, if the power consumed by the batter 25 is above a threshold, and/or if the battery 25 consumes power above a peak power, the risk of a hazard may be higher than a threshold, and therefore increased need for detecting wake up signals may be needed.

The environmental parameter associated with the battery 25 and/or the vehicle 1 may comprise any suitable environmental parameter which may alone or in combination predict a state of the battery 25, and/or a risk for the battery 25 to have a hazard. The environmental parameter may comprise and/or be based on any one or more out of:
an ambient temperature of the battery 25 and/or the vehicle 1, and
an atmospheric pressure of the battery 25 and/or the vehicle 1.

If there is a very high ambient temperature, e.g., above a first temperature threshold, or a very low temperature, e.g., below a second temperature threshold, the risk of a hazard may be high and therefore increased need for detecting wake up signals may be needed. This is since vehicle control system is typically based on an operating condition of the vehicle 1, and it may happen that vehicle 1 may run outside the operating condition which might lead to degradation of the battery 25 and increasing the probability of a hazard. For example, at very low temperatures, changing temperature is not considered good for the life of a battery 25: a vehicle control system may either prohibit such function or may provide recommendation to a user in what operation to perform.

Repetitive abuse of such recommendation and/or work conditions may lead to further degradation of the SoH and increase in the probability of hazard. Therefore, depending on a number of times an abuse of the cell limits have happened and correlating a slope to an SoH degradation curve may be used to compute the probability of hazard.

If there is a very high atmospheric pressure, e.g., above a first atmospheric pressure threshold, or a very low atmospheric pressure, e.g., below a second atmospheric pressure threshold, the risk of a hazard may be higher than a threshold, and therefore increased need for detecting wake up signals may be needed.

### Action 202

In some examples, the method comprises, by the processing circuitry 602, determining a respective duration associated with any one or both out of the one or more detection periods and the one or more idle periods based on the one or more parameters. The one or more parameters may be received in action 201 and/or as obtained otherwise in any suitable manner, e.g., as measured by one or more respective sensors distributed in the vehicle 1.

As indicated in Action 201, the one or more parameters may comprise any one or more out of: a SoH indicator of the battery 25, a usage profile of the battery 25, and an environmental parameter associated with the battery 25 and/or the vehicle 1, e.g., an ambient temperature and/or an atmospheric pressure of the battery 25 and/or the vehicle 1. However, the one or more parameters may additionally or alternatively also comprise one or more cell limit violations of the battery 25, e.g., as part of the usage profile of the battery 25. The one or more cell limit violations may be related to a counter and/or average time abused the battery 25 cells, which may lead to a higher risk of a hazard.

In some examples, when the one or more parameters comprise the usage profile of the battery 25, determining the respective duration associated with any one or both out of the one or more detection periods and the one or more idle periods based on one or more parameters, may comprises any one or both out of:
a. when the usage profile of the battery 25 indicates a charge or discharge of the battery 25 to be below a predefined intensity threshold, determining the duration of the one or more detection periods to a first detection duration, and/or determining the duration of the one or more idle periods to a first idle duration, and/or
b. when the usage profile of the battery 25 indicates a charge or discharge of the battery 25 to be above a predefined intensity threshold, determining the duration of the one or more detection period to a second detection duration, and/or determining the duration of the one or more idle periods to a second idle duration;

In the above example, the first detection duration is shorter than the second detection duration and/or the first idle duration is longer than the second idle duration.

In other words, when the usage profile of the battery 25 indicates a high intensity, e.g., more than the predefined intensity threshold, the one or more detection periods may be adjusted to be longer than if the usage profile of the battery 25 does not indicate a high intensity.

A rigorous/intense usage of the battery 25 would lead to a high number of charge/discharge cycles within a short period of time. This may result in early degradation of the battery 25. The early degradation may lead to increased risk of hazards, and thereby a need to detect wake up signals more often, e.g., to have longer duration in the one or more detection periods. In other words, the predefined intensity threshold may be a number of charge/discharge cycles for a set period of time.

The usage profile may also be a peak power or power over time which, if too high, may also lead to early degradation of the battery 25. The early degradation may lead to increased risk of hazards, and thereby a need to detect wake up signals more often, e.g., to have longer duration in the one or more detection periods. In other words, the predefined intensity threshold may be a peak power or power over time for a set period of time.

In some examples, when the one or more parameters comprise the SoH indicator of the battery 25, determining the respective duration associated with any one or both out of the one or more detection periods and the one or more idle periods based on one or more parameters, comprises any one or more out of:
a. when the SoH indicates that the SoH of the battery 25 fulfils a quality condition, determining the duration of the one or more detection periods to a first detection duration, and/or determining the duration of the one or more idle periods to a first idle duration, and/or
b. when the SoH indicates that the SoH of the battery 25 does not fulfil the quality condition, determining the duration of the one or more detection periods to a second detection duration, and/or determining the duration of the one or more idle periods to a second idle duration.

In the above example, the first detection duration is shorter than the second detection duration and/or the first idle duration is longer than the second idle duration.

In other words, when the SoH of the battery 25 indicates that the SoH of the battery 25 does not fulfil the quality condition, the one or more detection periods may be adjusted to be longer than if the SoH of the battery 25 fulfils the quality condition.

In some examples, the SoH may be represented as a percentage. 100-80% of the SoH of the battery 25 may be scaled to 100- 0% for a vehicle application of the vehicle 1. This means that 80% of the SoH may mean a 0% performance in the vehicle application. 0% may mean that the vehicle 1 is not able to perform a task to completion. Between 0 and 100% of vehicle application may mean that the vehicle 1 is able to perform a task to completion with some degradation, or partly to completion. 100% of vehicle application may mean that the vehicle 1 may perform a task to completion as intended.

When the SoH decreases by 1% unit, it may reflect a 5% degradation of the vehicle application. In these examples, when the SoH of the battery 25 is close to 80% i.e. equal or below 85% it may be considered as a state where a frequency of monitoring needs to be increased exponentially/linearly based on a rate of degradation of the battery 25, e.g., a capacity fade, and/or the usage profile and/or operating condition, e.g., as part of the one or more parameters above. In some examples, estimations of the above percentages may have some accuracy errors, which may be accounted for in the quality condition. In other words, those cases, if the accuracy is +/- 2%, hazards may be considered from 87% onwards.

While percentages are mentioned above, any other unit may also apply.

In other words the quality condition may be fulfilled when the SoH of the battery 25 is high enough or higher than a threshold for a predetermined time period.

As an alternative, the duration of the one or more idle periods and/or the one or more detection periods may be directly mapped to the SoH, e.g., by a mathematical function, e.g., a predefined mapping function. The predefined mapping function may be a linear or exponential function. In these examples, a high SoH may be mapped to a short duration for the one or more detection periods, and a low SoH may be mapped to a long duration for the one or more detection periods, e.g., longer than the short duration.

As a non-limiting example, the short duration may be, 'n' time in every hour, e.g., n=2, for a period of `T1' secs e.g., Tl=5. n may be a positive integer. T1 may be a positive integer.

As a non-limiting example, the long duration may be to wake up 'n' times every hour n=30 and each wake up, the vehicle 1 may duty cycle for the entire minute for a time-period, e.g., Ton=5; Toff= 5, i.e. within that minute it wakes up for 5 secs to listen for a wake-up signal and sleeps for another 5 secs and repeats it for 6 times throughout the minute before going to deep sleep for another minute. In this example, n may be a positive integer. Ton may be a positive integer. Toff may be a positive integer

In some examples, determining the respective duration associated with any one or both out of the one or more detection periods and the one or more idle periods are based on a timing configuration indicative of when the wake up signal 30 can be transmitted from a BMS 20 associated with the battery 25.

The timing configuration may be based on any one or more out of:
a. the SoH indicator of the battery 25,
b. the usage profile of the battery 25, and
c. the environmental parameter associated with the battery 25 and/or the vehicle 1, e.g., an ambient temperature and/or an atmospheric pressure of the battery 25 and/or the vehicle 1.

In other words, the one or more detection periods and/or the one or more idle periods may be synchronized in time and/or duration such that the one or more detection periods are arranged to be when a wake up signal is transmitted from the BMS 20, e.g., from the transmitter 22.

In some examples, the timing configuration is indicative of any one or more out of:
a. one or more first BMS time periods when the BMS 20 is configured to transmit a wake up signal 30 in response to a sensed hazard of the battery 25, and/or
b. one or more second BMS time periods when the BMS 20 is configured to refrain from detecting sensed hazards of the battery 25, e.g., to refrain from sending the sensed hazard of the battery 25.

The one or more second BMS time periods may be time periods when the BMS 20 is configured to be idle, e.g., when to not transmit wake up signals and/or detect hazards of the battery 25. In this way, the BMS 20 may save energy by only sensing hazards during the first BMS time periods.

In other words, the one or more detection periods may be arranged to be synchronized in time and/or duration with the first BMS time period. The one or more idle periods may be arranged to be synchronized in time and/or duration with the second BMS time period.

In some examples, the first and/or second BMS time periods may be synchronized with the one or more idle periods and/or the one or more detection periods by synchronizing a clock of the ECU 11 of the vehicle 1, e.g., used for timing when to initiate the one or more idle periods and/or the one or more detection periods, with a clock of the BMS 20. The clock of the BMS 20 may be used for timing of when to initiate the first and/or the second BMS time periods. The ECU 11 clock of the vehicle 1, e.g., as part of the computer system 600, and the BMS clock of the BMS 20 may be synchronized during normal operations, e.g., before the vehicle is configured in a low power mode such as in a parking mode.

In some examples, determining the respective duration associated with any one or both out of the one or more detection periods and the one or more idle periods may comprise determining the durations such that if the transmitter 22 is transmitting wake up signals, an upper bound for when to latest detect the wake up signal 30 is established, e.g., 1 second and/or an upper for how many missed wake up signals is missed at most is established, e.g., at most missed 1 wake up signal.

In some examples determining the respective duration associated with any one or both out of the one or more detection periods and the one or more idle periods may further comprise determining, e.g., synchronizing, a timing of the one or more detection periods and the one or more idle periods. The timing of the one or more detection periods and the one or more idle periods may be determined to match with idle and transmitting periods of the BMS 20.

### Action 203

The method comprises, by a processing circuitry 602 comprised in a computer system 600, during one or more detection periods, attempting to detect the wake up signal 30.

Attempting to detect the wake up signal 30 may mean that the received 10 is, during the one or more detection periods, configured to listen for incoming wake up signals, e.g., wireless signals

While examples herein discuss a single wake up signal 30, the BMS 20 may still transmit many wake up signals repeatedly. The wake up signal 30 may thus be the one wake up signal 30 that is eventually detected by the receiver 10.

During the one or more detection periods, the vehicle 1 may be arranged in a low power mode, such as in a parking mode.

### Action 204

The method comprises, by the processing circuitry 602, during one or more idle periods, refraining from attempting to detect the wake up signal 30.

Refraining from attempting to detect the wake up signal 30 may comprise configuring the receiver 10, during the one or more idle periods, to not listen for the wake up signal 30. This may mean to configure the received 10 to be turned off and/or to be in a low power mode where the receiver 10 does not listen for wake up signals.

During the one or more idle periods, the vehicle 1 may be arranged in a low power mode, such as in a parking mode.

In combination with action 203, the one or more detection periods and the one or more idle periods may be referred to as duty cycling the receiver 10.

### Action 205

In some examples, the method comprises detecting the wake up signal 30.

The detection may be performed when attempting to detect the wake up signal 30 during the one or more detection period 310, e.g., by receiving the wake up signal 30 using the receiver 10. The wake up signal may be transmitted by the transmitter 22 of the BMS 20.

When detecting the wake up signal 30, the vehicle 1 may be woken up from the low power mode, e.g., by waking up the ECU 11. In other words, the ECU 11 may be triggered to wake up from an idle mode to a normal operations mode.

### Action 206

In some examples, the method comprises by the processing circuitry 602, in response to detecting 205 the wake up signal 30, triggering 206 an alert.

Triggering the alert may comprise triggering any one or more out of:
a. Triggering an external and/or internal sound and/or light alarm, and/or
b. Triggering a request to an external entity, fire department, security department e.g., an SOS alarm

In other words, triggering the alert may comprise triggering any suitable sorts of alarms, primarily to alert a driver in case they are inside the vehicle 1. It may further be used to trigger audio alarm for the people or vehicle in close proximity of the vehicle 1. It may also be used to trigger a SOS.

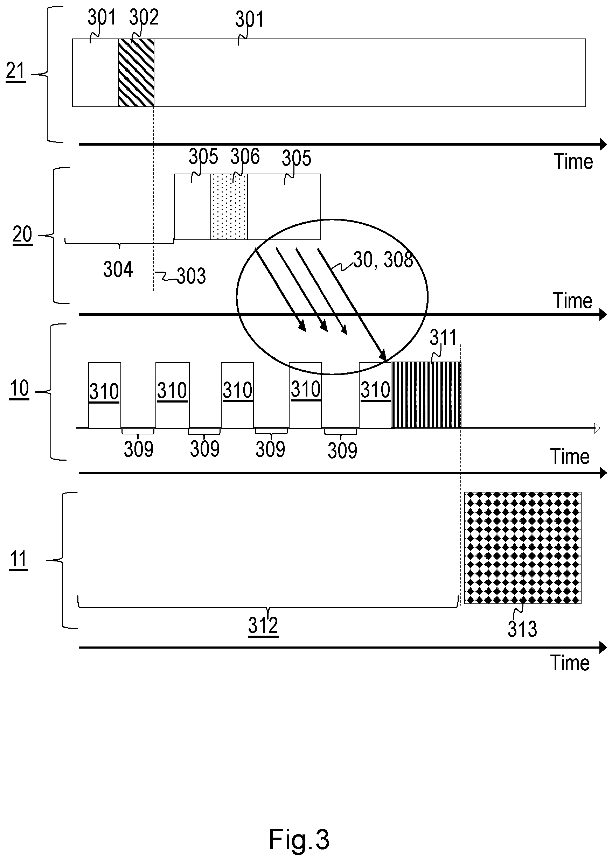

**FIG. 3** is a schematic diagram illustrating an example scenario.

FIG. 3 illustrates a number of diagrams of what happens during a hazard, e.g., a thermal runaway.

The sensor 21 is always in detection mode and will during its **ON-state 301** sense for the hazard. During **first time period 302** a hazard is detected and the BMS 20 is notified at a **first point in time 303.** The notification may continue to be applied, until the BMS 20 has taken action and started to send wake up signals.

The BMS 20 may at this time be in an idle state during a **BMS idle period 304,** e.g., in the second BMS period as discussed above, and may therefore not react until a **BMS detection period 305.**

The BMS 20 may immediately detect the hazard as notified from the sensor 21 and/or there may be some delay for preparing a wake up signal in the **transmit time period 306.** During the transmit period 306, the BMS 20 may start to transmit **wake up signals 308** towards the receiver 10, including the wake up signal 30.

The receiver 10 may be arranged to have **one or more detection periods 310** for attempting to detect the wake up signal 30, and with **one or more idle periods 309** wherein the receiver 10 is configured to not detect incoming wake up signals and instead save power, e.g., as in actions 203-204 above.

In one of the one or more detection periods 310, the wake up signal 30 is detected by the receiver 10, e.g., as in action 203 above. Detecting by the receiver 10 may wake up the ECU 11 of the vehicle 1, e.g., as part of the computer system 600. Waking up the ECU 11 may be initiated during a **wake up period 311.** The ECU 11 may initially be in a low power mode such as a parking mode during a **sleep period 312,** and after the wake up period the ECU 11 may be in a **normal operation mode 313,** e.g., a non-idle mode, e.g., which may be normal operation mode may be used for warning of the hazard, e.g., as in actions 205-206.

In some examples, a low-power wake-up receiver, e.g., the receiver 10 is provided. The receiver 10 is duty cycled, e.g., as in actions 203-204 combined, to listen to a probable wake up signal, e.g., the wake up signal 30, instead of keeping the power-hungry main controller or vehicle ECU, e.g., the ECU 11 and/or the computer system 600, to receive a possible paging from the BMS 20 when a hazard, e.g., a thermal event, has been detected. For example, the receiver 10 may be configured to duty cycle, e.g., as in actions 203-204 combined, during lower vehicle modes where parts or rest of the vehicle functionality is turned OFF for example in a parked mode, accessory mode, or in a sleep mode.

Examples herein may relate to any one or more out of the following features:
1. Enhance a safety feature availability of an Energy Storage System (ESS) of the vehicle 1.
2. Improve a power saving of the battery 25 and/or the vehicle 1 by the duty cycling of the low power wake-up receiver 10,

Examples herein may further comprise any one or more out of the following:

A duty cycle pattern of a thermal runaway detection circuitry, e.g., the sensor 21, may be based on a function of a SoH of the battery 25, previous usage profile of the battery 25 and/or current operating conditions of the vehicle 1 and/or the battery 25. In some examples, the sensor 21 may always detect a hazard, but the BMS 20 may only react to the sensed hazard based on the duty cycling, and may be idle for periods to save power.

This may mean more frequent duty cycling at low SoH, more frequent duty cycling at boundary operating condition, e.g., example ambient temperature, and atmospheric pressure, and more frequent duty cycling after intense charge and discharge cycles.

The receiver 10 may be duty cycled in a corresponding manner to save power.

The receiver 10 may be duty cycled such that it would not miss two consecutive wake-up signals transmitted by the transmitter 22. Hence the duty cycling technique for the receiver is dependent on the duty cycle technique of the BMS 20 and/or the sensor 21.

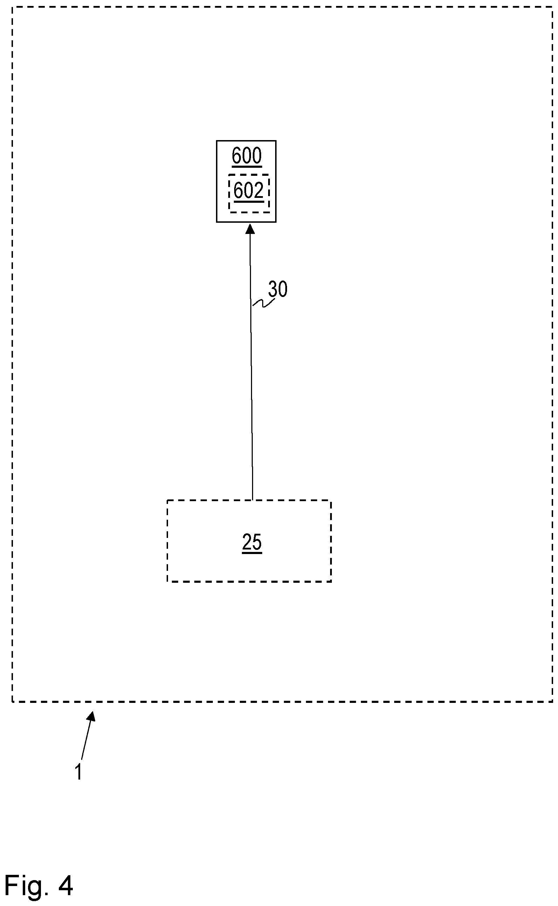

**FIG. 4** is another view of **FIG. 1****,** according to an example.

The example of FIG. 4 illustrates the computer system 600 comprising processing the circuitry 602 configured to handle detection of the wake up signal 30 indicative of a hazard in the battery 25 associated with the vehicle 1, the processing circuitry 602 is further configured to:
during one or more detection periods, attempt to detect the wake up signal 30, and
during one or more idle periods, refrain from attempting to detect the wake up signal 30.

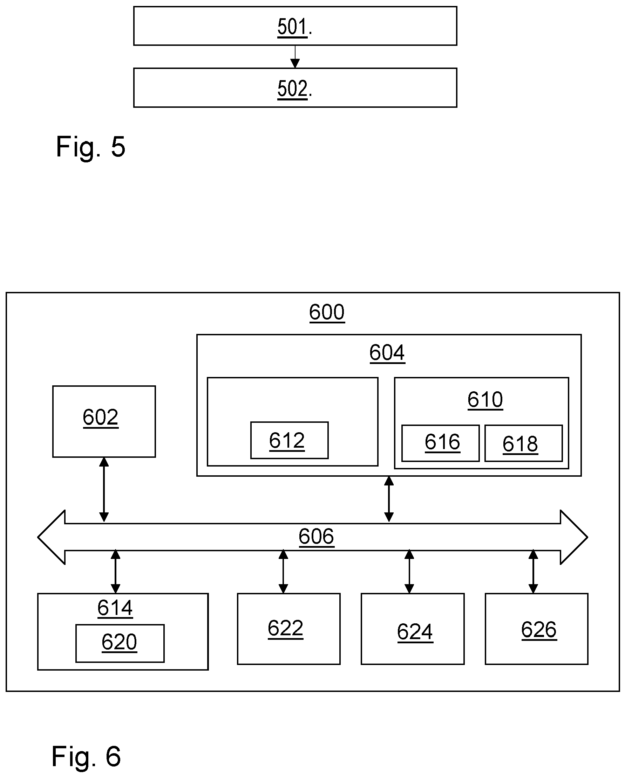

**FIG. 5** is a flow chart of a method according to an example. The method of FIG. 5 may be combined in any suitable manner with the method of FIG.2, and vice versa. The method of FIG. 5 is an example computer-implemented method for handling detection of the wake up signal 30. The wake up signal 30 is indicative of a hazard in the battery 25. The battery is associated with the vehicle 1.

The method illustrated in FIG. 5 comprises the following actions listed below.

### Action 501.

The method comprises: by the processing circuitry 602 comprised in the computer system 600, during one or more detection periods, attempting to detect the wake up signal 30.

### Action 502.

The method comprises: by the processing circuitry 602, during one or more idle periods, refraining 502 from attempting to detect the wake up signal 30.

**FIG. 6** is a schematic diagram of the computer system **600** for implementing examples disclosed herein, e.g., as also exemplified in Figs. 1 and 4. The computer system **600** is adapted to execute instructions from a computer-readable medium to perform these and/or any of the functions or processing described herein. The computer system **600** may be connected (e.g., networked) to other machines in a LAN, an intranet, an extranet, or the Internet. While only a single device is illustrated, the computer system **600** may include any collection of devices that individually or jointly execute a set (or multiple sets) of instructions to perform any one or more of the methodologies discussed herein. Accordingly, any reference in the disclosure and/or claims to a computer system, computing system, computer device, computing device, control system, control unit, electronic control unit (ECU), processor device, processing circuitry, etc., includes reference to one or more such devices to individually or jointly execute a set (or multiple sets) of instructions to perform any one or more of the methodologies discussed herein. For example, control system may include a single control unit or a plurality of control units connected or otherwise communicatively coupled to each other, such that any performed function may be distributed between the control units as desired. Further, such devices may communicate with each other or other devices by various system architectures, such as directly or via a Controller Area Network (CAN) bus, etc.

The computer system **600** may comprise at least one computing device or electronic device capable of including firmware, hardware, and/or executing software instructions to implement the functionality described herein. The computer system **600** may include the processing circuitry **602** (e.g., processing circuitry including one or more processor devices or control units), a memory **604,** and a system bus **606,** e.g., as also exemplified in Figs. 1 and 4. The computer system **600** may include at least one computing device having the processing circuitry **602.** The system bus **606** provides an interface for system components including, but not limited to, the memory **604** and the processing circuitry **602.** The processing circuitry **602** may include any number of hardware components for conducting data or signal processing or for executing computer code stored in memory **604.** The processing circuitry **602** may, for example, include a general-purpose processor, an application specific processor, a Digital Signal Processor (DSP), an Application Specific Integrated Circuit (ASIC), a Field Programmable Gate Array (FPGA), a circuit containing processing components, a group of distributed processing components, a group of distributed computers configured for processing, or other programmable logic device, discrete gate or transistor logic, discrete hardware components, or any combination thereof designed to perform the functions described herein. The processing circuitry **602** may further include computer executable code that controls operation of the programmable device.

The system bus **606** may be any of several types of bus structures that may further interconnect to a memory bus (with or without a memory controller), a peripheral bus, and/or a local bus using any of a variety of bus architectures. The memory **604** may be one or more devices for storing data and/or computer code for completing or facilitating methods described herein. The memory **604** may include database components, object code components, script components, or other types of information structure for supporting the various activities herein. Any distributed or local memory device may be utilized with the systems and methods of this description. The memory **604** may be communicably connected to the processing circuitry **602** (e.g., via a circuit or any other wired, wireless, or network connection) and may include computer code for executing one or more processes described herein. The memory **604** may include non-volatile memory **608** (e.g., read-only memory (ROM), erasable programmable read-only memory (EPROM), electrically erasable programmable read-only memory (EEPROM), etc.), and volatile memory **610** (e.g., random-access memory (RAM)), or any other medium which can be used to carry or store desired program code in the form of machine-executable instructions or data structures and which can be accessed by a computer or other machine with processing circuitry **602.** A basic input/output system (BIOS) **612** may be stored in the non-volatile memory **608** and can include the basic routines that help to transfer information between elements within the computer system **600.**

The computer system **600** may further include or be coupled to a non-transitory computer-readable storage medium such as the storage device **614,** which may comprise, for example, an internal or external hard disk drive (HDD) (e.g., enhanced integrated drive electronics (EIDE) or serial advanced technology attachment (SATA)), HDD (e.g., EIDE or SATA) for storage, flash memory, or the like. The storage device **614** and other drives associated with computer-readable media and computer-usable media may provide non-volatile storage of data, data structures, computer-executable instructions, and the like.

Computer-code which is hard or soft coded may be provided in the form of one or more modules. The module(s) can be implemented as software and/or hard-coded in circuitry to implement the functionality described herein in whole or in part. The modules may be stored in the storage device **614** and/or in the volatile memory **610,** which may include an operating system **616** and/or one or more program modules **618.** All or a portion of the examples disclosed herein may be implemented as a computer program **620** stored on a transitory or non-transitory computer-usable or computer-readable storage medium (e.g., single medium or multiple media), such as the storage device **614,** which includes complex programming instructions (e.g., complex computer-readable program code) to cause the processing circuitry **602** to carry out actions described herein. Thus, the computer-readable program code of the computer program **620** can comprise software instructions for implementing the functionality of the examples described herein when executed by the processing circuitry **602.** In some examples, the storage device **614** may be a computer program product (e.g., readable storage medium) storing the computer program **620** thereon, where at least a portion of a computer program **620** may be loadable (e.g., into a processor) for implementing the functionality of the examples described herein when executed by the processing circuitry **602.** The processing circuitry **602** may serve as a controller or control system for the computer system **600** that is to implement the functionality described herein.

In some examples, the computer system 600 or the processing circuitry 602 may be represented by and/or may be part of the ECU 11 or any other suitable ECU in the vehicle 1.

The computer system **600** may include an input device interface **622** configured to receive input and selections to be communicated to the computer system **600** when executing instructions, such as from a keyboard, mouse, touch-sensitive surface, etc. Such input devices may be connected to the processing circuitry **602** through the input device
interface **622** coupled to the system bus **606** but can be connected through other interfaces, such as a parallel port, an Institute of Electrical and Electronic Engineers (IEEE) 1394 serial port, a Universal Serial Bus (USB) port, an IR interface, and the like. The computer system **600** may include an output device interface **624** configured to forward output, such as to a display, a video display unit (e.g., a liquid crystal display (LCD) or a cathode ray tube (CRT)). The computer system **600** may include a communications interface **626** suitable for communicating with a network as appropriate or desired.

The operational actions described in any of the exemplary aspects herein are described to provide examples and discussion. The actions may be performed by hardware components, may be embodied in machine-executable instructions to cause a processor to perform the actions, or may be performed by a combination of hardware and software. Although a specific order of method actions may be shown or described, the order of the actions may differ. In addition, two or more actions may be performed concurrently or with partial concurrence.

Further examples will follow below. The below examples may be combined with any one or more other examples herein, in any suitable manner.
**Example 1.** A computer system 600 comprising processing circuitry 602 configured to handle detection of a wake up signal 30 indicative of a hazard in a battery 25 associated with a vehicle 1, the processing circuitry 602 being further configured to:
   - during one or more detection periods 310, attempt to detect the wake up signal 30, and
   - during one or more idle periods 309, refrain from attempting to detect the wake up signal 30.
**Example 2.** The computer system 600 of Example 1, wherein during the one or more detection periods 310 and/or the one or more idle periods 309, the vehicle 1 is arranged in a low power mode.
**Example 3.** The computer system 600 of any one of Examples 1 to 2, wherein the processing circuitry 602 being further configured to:
   - determine a respective duration associated with any one or both out of the one or more detection periods 310 and the one or more idle periods 309 based on one or more parameters, the one or more parameters comprising any one or more out of:
      i. a State of Health, SoH, indicator of the battery 25,
      ii. a usage profile of the battery 25, and
      iii. an environmental parameter associated with the battery 25 and/or the vehicle 1.
**Example 4.** The computer system 600 of Example 3, wherein when the one or more parameters comprise the usage profile of the battery 25, the processing circuitry 602 is configured to determine the respective duration associated with any one or both out of the one or more detection periods 310 and the one or more idle periods 309 based on one or more parameters, by any one or more out of:
   - when the usage profile of the battery 25 indicate a charge or discharge of the battery 25 to be below a predefined intensity threshold, the duration of the one or more detection periods 310 is determined to be a first detection duration, and/or the duration of the one or more idle periods 309 is determined to be a first idle duration,
   - when the usage profile of the battery 25 indicate a charge or discharge of the battery 25 to be above a predefined intensity threshold, the duration of the one or more detection periods 310 is determined to be a second detection duration, and/or the duration of the one or more idle periods 309 is determined to be a second idle duration, and
   - wherein the first detection duration is shorter than the second detection duration and/or the first idle duration is longer than the second idle duration.
**Example 5.** The computer system 600 of any one of Examples 3-4, wherein when the one or more parameters comprise the SoH indicator of the battery 25, the processing circuitry 602 is configured to determine the respective duration associated with any one or both out of the one or more detection periods 310 and the one or more idle periods 309 based on one or more parameters, by any one or more out of:
   - when the SoH indicates that the SoH of the battery 25 fulfils a quality condition, the duration of the one or more detection periods 310 is determined to be a first detection duration, and/or the duration of the one or more idle periods 309 is determined to be a first idle duration,
   - when the SoH indicates that the SoH of the battery 25 does not fulfil the quality condition, the duration of the one or more detection periods 310 is determined to be a second detection duration, and/or the duration of the one or more idle periods 309 is determined to be a second idle duration, and
   - wherein the first detection duration is shorter than the second detection duration and/or the first idle duration is longer than the second idle duration.
**Example 6.** The computer system 600 of any one of Examples 1 to 5, wherein the processing circuitry 602 being further configured to receive at least part of the one or more parameters from a Battery Management System, BMS, associated with the battery 25.
**Example** 7. The computer system 600 of any one of Examples 1 to 6, wherein the processing circuitry 602 being further configured to determine the respective duration associated with any one or both out of the one or more detection periods 310 and the one or more idle periods 309 based on a timing configuration indicative of when the wake up signal 30 can be transmitted from a Battery Management System, BMS, associated with the battery 25.
**Example 8.** The computer system 600 of Example 7, wherein the timing configuration is indicative of any one or more out of:
   - one or more first BMS time periods when the BMS is configured to transmit the wake up signal 30 in response to a sensed hazard of the battery 25,
   - one or more second BMS time periods when the BMS is configured to refrain from detecting sensed hazards of the battery 25.
**Example 9.** The computer system 600 of any one of Examples 1-8, wherein the processing circuitry 602 being further configured to:
   - in response to detecting the wake up signal 30, triggering an alert.
**Example 10.** A vehicle 1 comprising the computer system 600 of any of Examples 1-9.
**Example 11.** A computer-implemented method, for handling detection of a wake up signal 30 indicative of a hazard in a battery 25 associated with a vehicle 1, the method comprising:
   - by a processing circuitry 602 comprised in a computer system 600, during one or more detection periods 310, attempting 203, 501 to detect the wake up signal 30, and
   - by the processing circuitry 602, during one or more idle periods 309, refraining 204, 502 from attempting to detect the wake up signal 30.
**Example 12.** The method of Example 11, wherein during the one or more detection periods 310 and/or the one or more idle periods 309, the vehicle is arranged in a low power mode, such as in a parking mode.
**Example 13.** The method of any one of Examples 11 to 12, wherein the method further comprises:
   - by the processing circuitry 602, determining 202 a respective duration associated with any one or both out of the one or more detection periods 310 and the one or more idle periods 309 based on one or more parameters, the one or more parameters comprising any one or more out of:
      i. a State of Health, SoH, indicator of the battery 25,
      ii. a usage profile of the battery 25, and
      iii. an environmental parameter associated with the battery 25 and/or the vehicle 1, e.g., an ambient temperature and/or an atmospheric pressure of the battery 25 and/or the vehicle 1.
**Example 14.** The method of Example 13, wherein when the one or more parameters comprise the usage profile of the battery 25, determining 202 the respective duration associated with any one or both out of the one or more detection periods 310 and the one or more idle periods 309 based on one or more parameters, comprises any one or both out of:
   - when the usage profile of the battery 25 indicate a charge or discharge of the battery 25 to be below a predefined intensity threshold, determining the duration of the one or more detection periods 310 to a first detection duration, and/or determining the duration of the one or more idle periods 309 to a first idle duration, and
   - when the usage profile of the battery 25 indicate a charge or discharge of the battery 25 to be above a predefined intensity threshold, determining the duration of the one or more detection periods 310 to a second detection duration, and/or determining the duration of the one or more idle periods 309 to a second idle duration;
   - wherein the first detection duration is shorter than the second detection duration and/or the first idle duration is longer than the second idle duration.
**Example 15.** The method of any one of Examples 13-14, wherein when the one or more parameters comprise the SoH indicator of the battery 25, determining 202 the respective duration associated with any one or both out of the one or more detection periods 310 and the one or more idle periods 309 based on one or more parameters, comprises any one or more out of:
   - when the SoH indicate that the SoH of the battery 25 fulfils a quality condition, determining the duration of the one or more detection periods 310 to a first detection duration, and/or determining the duration of the one or more idle periods 309 to a first idle duration, and/or
   - when the SoH indicate that the SoH of the battery 25 does not fulfil the quality condition, determining the duration of the one or more detection periods 310 to a second detection duration, and/or determining the duration of the one or more idle periods 309 to a second idle duration;
   - wherein the first detection duration is shorter than the second detection duration and/or the first idle duration is longer than the second idle duration.
**Example 16.** The method of any one of Examples 11 to 15, wherein the method further comprises:
   - by the processing circuitry 602, receiving 201 at least part of the one or more parameters from a Battery Management System, BMS, associated with the battery 25.
**Example 17.** The method of any one of Examples 11 to 16, wherein determining 202 the respective duration associated with any one or both out of the one or more detection periods 310 and the one or more idle periods 309 is based on a timing configuration indicative of when the wake up signal 30 can be transmitted from a BMS associated with the battery 25.
**Example 18.** The method of Example 17, wherein the timing configuration is indicative of any one or more out of:
   - one or more first BMS time periods when the BMS is configured to transmit a wake up signal 30 in response to a sensed hazard of the battery 25,
   - one or more second BMS time periods when the BMS is configured to refrain from detecting sensed hazards of the battery 25.
**Example 19.** The method of any one of Examples 11-18, wherein the method further comprises:
   - by the processing circuitry 602, in response to detecting 205 the wake up signal 30, triggering 206 an alert.
**Example 20.** A computer program product comprising program code for performing, when executed by the processing circuitry 602, the method of any of Examples 11-19.
**Example 21.** A non-transitory computer-readable storage medium comprising instructions, which when executed by the processing circuitry 602, cause the processing circuitry 602 to perform the method of any of Examples 11-19.

The terminology used herein is for the purpose of describing particular aspects only and is not intended to be limiting of the disclosure. As used herein, the singular forms "a," "an," and "the" are intended to include the plural forms as well, unless the context clearly indicates otherwise. As used herein, the term "and/or" includes any and all combinations of one or more of the associated listed items. It will be further understood that the terms "comprises," "comprising," "includes," and/or "including" when used herein specify the presence of stated features, integers, actions, steps, operations, elements, and/or components, but do not preclude the presence or addition of one or more other features, integers, actions, steps, operations, elements, components, and/or groups thereof.

It will be understood that, although the terms first, second, etc., may be used herein to describe various elements, these elements should not be limited by these terms. These terms are only used to distinguish one element from another. For example, a first element could be termed a second element, and, similarly, a second element could be termed a first element without departing from the scope of the present disclosure.

Relative terms such as "below" or "above" or "upper" or "lower" or "horizontal" or "vertical" may be used herein to describe a relationship of one element to another element as illustrated in the Figures. It will be understood that these terms and those discussed above are intended to encompass different orientations of the device in addition to the orientation depicted in the Figures. It will be understood that when an element is referred to as being "connected" or "coupled" to another element, it can be directly connected or coupled to the other element, or intervening elements may be present. In contrast, when an element is referred to as being "directly connected" or "directly coupled" to another element, there are no intervening elements present.

Unless otherwise defined, all terms (including technical and scientific terms) used herein have the same meaning as commonly understood by one of ordinary skill in the art to which this disclosure belongs. It will be further understood that terms used herein should be interpreted as having a meaning consistent with their meaning in the context of this specification and the relevant art and will not be interpreted in an idealized or overly formal sense unless expressly so defined herein.

It is to be understood that the present disclosure is not limited to the aspects described above and illustrated in the drawings; rather, the skilled person will recognize that many changes and modifications may be made within the scope of the present disclosure and appended claims. In the drawings and specification, there have been disclosed aspects for purposes of illustration only and not for purposes of limitation, the scope of the disclosure being set forth in the following claims.

## Claims

1. A computer system (600) comprising processing circuitry (602) configured to handle detection of a wake up signal (30) indicative of a hazard in a battery (25) associated with a vehicle (1), the processing circuitry (602) being further configured to:
- during one or more detection periods (310), attempt to detect the wake up signal (30), and
- during one or more idle periods (309), refrain from attempting to detect the wake up signal (30).

2. The computer system (600) of claim 1, wherein during the one or more detection periods (310) and/or the one or more idle periods (309), the vehicle (1) is arranged in a low power mode.

3. The computer system (600) of any one of claims 1 to 2, wherein the processing circuitry (602) being further configured to:
- determine a respective duration associated with any one or both out of the one or more detection periods (310) and the one or more idle periods (309) based on one or more parameters, the one or more parameters comprising any one or more out of:
i. a State of Health, SoH, indicator of the battery (25),
ii. a usage profile of the battery (25), and
iii. an environmental parameter associated with the battery (25) and/or the vehicle (1).

4. The computer system (600) of claim 3, wherein when the one or more parameters comprise the usage profile of the battery (25), the processing circuitry (602) is configured to determine the respective duration associated with any one or both out of the one or more detection periods (310) and the one or more idle periods (309) based on one or more parameters, by any one or more out of:
- when the usage profile of the battery (25) indicate a charge or discharge of the battery (25) to be below a predefined intensity threshold, the duration of the one or more detection periods (310) is determined to be a first detection duration, and/or the duration of the one or more idle periods (309) is determined to be a first idle duration,
- when the usage profile of the battery (25) indicate a charge or discharge of the battery (25) to be above a predefined intensity threshold, the duration of the one or more detection periods (310) is determined to be a second detection duration, and/or the duration of the one or more idle periods (309) is determined to be a second idle duration, and
- wherein the first detection duration is shorter than the second detection duration and/or the first idle duration is longer than the second idle duration.

5. The computer system (600) of any one of claims 3-4, wherein when the one or more parameters comprise the SoH indicator of the battery (25), the processing circuitry (602) is configured to determine the respective duration associated with any one or both out of the one or more detection periods (310) and the one or more idle periods (309) based on one or more parameters, by any one or more out of:
- when the SoH indicates that the SoH of the battery (25) fulfils a quality condition, the duration of the one or more detection periods (310) is determined to be a first detection duration, and/or the duration of the one or more idle periods (309) is determined to be a first idle duration,
- when the SoH indicates that the SoH of the battery (25) does not fulfil the quality condition, the duration of the one or more detection periods (310) is determined to be a second detection duration, and/or the duration of the one or more idle periods (309) is determined to be a second idle duration, and
- wherein the first detection duration is shorter than the second detection duration and/or the first idle duration is longer than the second idle duration.

6. The computer system (600) of any one of claims 1 to 5, wherein the processing circuitry (602) being further configured to receive at least part of the one or more parameters from a Battery Management System, BMS, associated with the battery (25).

7. The computer system (600) of any one of claims 1 to 6, wherein the processing circuitry (602) being further configured to determine the respective duration associated with any one or both out of the one or more detection periods (310) and the one or more idle periods (309) based on a timing configuration indicative of when the wake up signal (30) can be transmitted from a Battery Management System, BMS, associated with the battery (25).

8. The computer system (600) of claim 7, wherein the timing configuration is indicative of any one or more out of:
- one or more first BMS time periods when the BMS is configured to transmit the wake up signal (30) in response to a sensed hazard of the battery (25),
- one or more second BMS time periods when the BMS is configured to refrain from detecting sensed hazards of the battery (25).

9. The computer system (600) of any one of claims 1-8, wherein the processing circuitry (602) being further configured to:
- in response to detecting the wake up signal (30), triggering an alert.

10. A vehicle (1) comprising the computer system (600) of any of claims 1-9.

11. A computer-implemented method, for handling detection of a wake up signal (30) indicative of a hazard in a battery (25) associated with a vehicle (1), the method comprising:
- by a processing circuitry (602) comprised in a computer system (600), during one or more detection periods (310), attempting (203, 501) to detect the wake up signal (30), and
- by the processing circuitry (602), during one or more idle periods (309), refraining (204, 502) from attempting to detect the wake up signal (30).

12. The method of claim 11, wherein during the one or more detection periods (310) and/or the one or more idle periods (309), the vehicle is arranged in a low power mode, such as in a parking mode.

13. The method of any one of claims 11 to 12, wherein the method further comprises:
- by the processing circuitry (602), determining (202) a respective duration associated with any one or both out of the one or more detection periods (310) and the one or more idle periods (309) based on one or more parameters, the one or more parameters comprising any one or more out of:
i. a State of Health, SoH, indicator of the battery (25),
ii. a usage profile of the battery (25), and
iii. an environmental parameter associated with the battery (25) and/or the vehicle (1), e.g., an ambient temperature and/or an atmospheric pressure of the battery (25) and/or the vehicle (1).

14. A computer program product comprising program code for performing, when executed by the processing circuitry (602), the method of any of claims 11-13.

15. A non-transitory computer-readable storage medium comprising instructions, which when executed by the processing circuitry (602), cause the processing circuitry (602) to perform the method of any of claims 11-13.
